Europäisches Patentamt

European Patent Office

Office européen des brevets

(11) Veröffentlichungsnummer : **0 043 065**
**B1**

(12) EUROPÄISCHE PATENTSCHRIFT

(45) Veröffentlichungstag der Patentschrift :
20.02.85

(21) Anmeldenummer : 81104789.3

(22) Anmeldetag : 22.06.81

(51) Int. Cl.⁴ : **H 03 H  7/48**

(54) **In eine geschirmte Busleitung einschaltbarer Signalkoppler.**

(30) Priorität : 25.06.80 DE 3023847

(43) Veröffentlichungstag der Anmeldung :
06.01.82 Patentblatt 82/01

(45) Bekanntmachung des Hinweises auf die Patenterteilung : 20.02.85 Patentblatt 85/08

(84) Benannte Vertragsstaaten :
AT BE CH FR GB LI NL

(56) Entgegenhaltungen :
DE-A- 2 233 501
US-A- 3 544 921

(73) Patentinhaber : **Siemens Aktiengesellschaft**
**Berlin und München Wittelsbacherplatz 2**
**D-8000 München 2 (DE)**

(72) Erfinder : **Humi, Franz, Dr.**
**Danziger Strasse 16**
**D-7500 Karlsruhe (DE)**

**Beschreibung**

Die Erfindung betrifft einen in eine geschirmte Busleitung einschaltbaren Signalkoppler gemäß dem Oberbegriff des Anspruchs 1.

Aus der DE-AS 22 33 501 ist eine Anordnung zum Auskoppeln von Signalen aus einer Busleitung bekannt, die einen Übertrager enthält, dessen Primärwicklung als zumindest einen Schenkel des Magnetkerns des Übertragers umschlingende Leiterbahn einer Leiterplatte ausgebildet ist. Parallel zur Leiterplatte sind zwei mit dem Schirm der Busleitung elektrisch verbundene Abschirmplatten in solchem Abstand angeordnet, daß die Leiterbahn den Wellenwiderstand der Busleitung besitzt. Die bekannte Anordnung hat den Nachteil, daß Storimpulse, die zwischen der Busleitung und dem jeweiligen Empfänger auftreten, nicht ausreichend abgeschirmt werden.

Der vorliegenden Erfindung liegt die Aufgabe zugrunde, die bekannte Anordnung dahin zu verbessern, daß die Störsignale, die zwischen der Busleitung und den Empfängern auftreten, besser unterdrückt werden.

Erfindungsgemäß wird diese Aufgabe mit den im kennzeichnenden Teil des Anspruchs 1 angegebenen Maßnahmen gelöst. Die Erfindung ist zum Ein- und Auskoppeln von Signalen in bzw. aus symmetrischen wie asymmetrischen Busleitungen geeignet.

Die Auswirkung der Störsignale auf den Empfänger kann dadurch weiter verringert werden, daß die Sekundärwicklung des Übertragers mit einer mit dem Nullpotential des Empfängers verbundenen Abschirmung versehen ist.

Hat der Übertrager zwei Schenkel, die durch jeweils zwei Löcher in den Abschirmplatten und de Leiterplatte hindurchgreifen, so können Kurzschlußströme in den Abschirmplatten dadurch verhindert werden, daß diese jeweils zwischen den beiden Löchern geschlitzt sind.

Eine vorteilhafte Ausbildung der Primärwicklung des Übertragers besteht darin, daß die Leiterplatte doppelt kaschiert ist und daß auf jeder Seite der doppelt kaschierten Leiterplatte eine mäanderförmige, die beiden Magnetkernschenkel in entgegengesetztem Sinn umlaufende Leiterbahn vorhanden ist. Die beiden Leiterbahnen sind im Falle einer asymmetrischen Busleitung an ihrem einen Ende miteinander verbunden und an ihren anderen Enden an die Busleitung angeschlossen. Sie verlaufen bezüglich der in den Magnetkernschenkeln liegenden Ebene symmetrisch, so daß sie sich zu Stromkreisen ergänzen, welche die Magnetkernschenkel umschließen. Eine derartige Ausbildung der Leiterbahnen hat den Vorteil, daß bei einem Strom durch die Busleitung und damit durch die Leiterbahnen sich die Magnetisierungen im Magnetkern addieren, die Streufelder sich aber kompensieren, und daß ferner ein Störfeld Signale bewirkt, welche entgegengesetzte Polarität haben und sich daher auf der Busleitung aufheben.

Eine vorteilhafte Anordnung zum Ein- und Auskoppeln von Signalen von bzw. in eine Busleitung ist im Anspruch 5 angegeben. Diese Anordnung zeichnet sich durch einen kompakten Aufbau, große Sicherheit gegen Störimpulse und einfache Herstellung aus.

Anhand der Zeichnung werden im folgenden die Erfindung sowie weitere Vorteile und Ausgestaltungen näher beschrieben und erläutert.

Es zeigen

Figur 1 ein Prinzipschaltbild einer Ausführungsform der Erfindung,

Figur 2 die konstruktive Ausgestaltung einer Weiterbildung der Erfindung mit asymmetrischer Busleitung und

Figur 3 eine Ausgestaltung mit symmetrischer Busleitung.

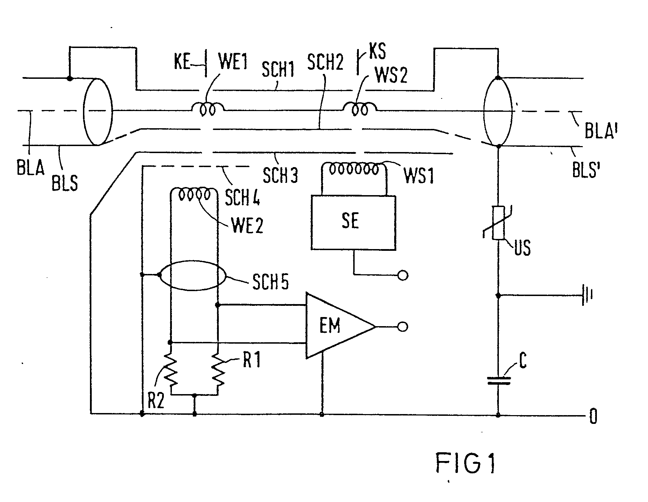

In Figur 1 ist mit BLA, BLA' die Ader einer koaxialen Busleitung bezeichnet, die von einem Schirm BLS, BLS' umgeben ist. Von dieser Busleitung sollen Signale zu einem Empfänger EM ausgekoppelt und von einem Sender SE in die Busleitung eingespeist werden. Zum Auskoppeln der Signale ist in die Busleitung eine Primärwicklung WE1 geschaltet, die auf einen Empfänger-Magnetkern KE gewickelt ist. Im Bereich dieses Magnetkerns ist die Busleitung als Leiterbahn einer Leiterplatte ausgebildet, die sich zwischen zwei Abschirmplatten SCH1, SCH2 befindet. Diese Abschirmplatten haben einen solchen Abstand von der Leiterplatte, daß die Leiterbahn den Wellenwiderstand der Ader BLA der Busleitung hat. Damit können auf der Busleitung Signale reflexionsfrei übertragen werden. Die Abschirmplatten SCH1, SCH2 sind mit dem Schirm BLS der koaxialen Busleitung verbunden.

Auf dem Empfänger-Magnetkern KE ist eine Sekundärwicklung WE2 angebracht, an die über eine symmetrische, mit einem Schirm SCH5 versehene Leitung der Empfänger EM angeschlossen ist. Zwischen den Eingängen des Empfängers EM und dessen Nullpotential liegen zwei Symmetrierwiderstände R1, R2.

Zur Verringerung der Amplitude von Störsignalen, die von der Busleitung auf die Empfängerwicklung WE2 gelangen können, ist eine dritte Abschirmplatte SCH3 zwischen der Abschirmplatte SCH2 und der Sekundärwicklung WE2 angeordnet. Sie liegt auf dem Nullpotential des Empfängers EM. Ihr Abstand zur Abschirmplatte SCH2 sollte möglichst groß sein, damit die zwischen diesen beiden Platten bestehende Kapazität möglichst klein ist. Zur weiteren Störsignalunterdrückung ist die Sekundärwicklung WE2 von einem Schirm SCH4 umgeben, der ebenso wie der Schirm SCH5 der Verbindungsleitung zwischen Sekundärspule WE2 und Empfänger EM auf Nullpotential gelegt ist. Über einen Kondensator C ist das Nullpotential mit dem Massepotential des Empfängers kapazitiv verbunden. Ein Überspannungsschutz US ist zwischen dem Massepotential und dem Schirm BLS der Busleitung angeordnet.

Der Sender SE speist eine Primärwicklung WS1, die auf einen Sender-Magnetkern KS gewickelt ist. Die zugehörige Sekundärwicklung WS2 ist in die Busleitung geschaltet. Eine der Abschirmung SCH4 entsprechende Abschirmung ist für die Primärwicklung WS1 des Sender-Übertragers nicht erforderlich.

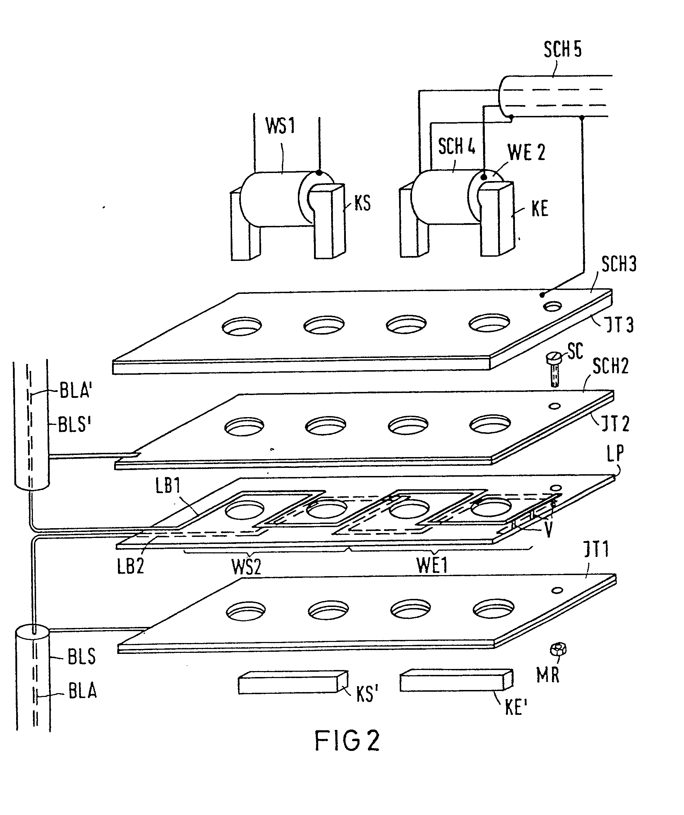

In Figur 2 ist mit BLA, BLA' ; BLS, BLS' wieder die koaxiale Busleitung bezeichnet. Im Bereich der Ein- und Auskoppelstelle ist die Signalader als Leiterbahn LB1, LB2 ausgebildet. Sie sind durch Ausätzen aus einer doppelt kaschierten Leiterplatte LP hergestellt. In diese sind vier Löcher gebohrt, durch welche die Schenkel der Magnetkerne KS, KS' ; KE, KE' gesteckt werden können. Die Leiterbahnen LB1, LB2 haben Mäanderform und sind um je zwei Löcher und damit um die Schenkel der Magnetkerne KS, KE in entgegengesetztem Sinne geführt. Ferner sind die Leiterbahnen LB1, LB2 bezüglich der Ebene, in welcher die Magnetkerne KS, KE liegen, symmetrisch angeordnet, so daß sie sich zu Stromkreisen ergänzen, welche die Schenkel der Magnetkerne umschließen. Zwischen den einen Enden der Leiterbahnen LB1, LB2 besteht eine elektrische Verbindung V. Fließt durch die Busleitung ein Strom, so erzeugt dieser im Bereich der beiden rechten Löcher der Leiterplatte LP zwei entgegengesetzte Magnetfelder, welche eine gleichsinnige Magnetisierung des Empfängermagnetkernes KE, KE' bewirken. In dessen Sekundärwicklung WE2 wird daher eine Spannung induziert, welche über die symmetrische Koaxialleitung mit dem Schirm SCH5 zum Empfänger übertragen wird. Die Streufelder der Primärwicklung WE1 sind entgegengerichtet und kompensieren sich in größerem Abstand von der Leiterplatte LP. Fremdfelder induzieren einander entgegengerichtete Spannungen und erzeugen daher keine Störimpulse.

Wird der auf dem Sender-Magnetkern KS sitzenden Primärwicklung WS1 vom in Figur 2 nicht dargestellten Sender ein Impuls zugeführt, so wird der Magnetkern KS magnetisiert und die Magnetflußänderung innerhalb der beiden linken Mäander der Leiterbahnen LB1, LB2 ist entgegengerichtet, so daß sich die dadurch in den Leiterbahnen LB1, LB2 induzierten Spannungen addieren und ein Signal auf die Busleitung gegeben wird. Die beiden linken Mäander der Leiterplatte LP bilden daher die Sekundärwicklung WS2 des Sender-Übertragers.

Auf beiden Seiten der Leiterplatte LP befinden sich die Abschirmplatten SCH1, SCH2, die jeweils aus einer Metallschicht bestehen, welche auf einen Träger IT1 bzw. IT2 aus Isolierstoff aufgebracht ist. Diese Metallschichten sind mit dem Schirm BLS, BLS' der Busleitung und untereinander mittels einer Schraube SC und einer Mutter MR elektrisch und mechanisch verbunden. Es besteht daher eine elektrische Verbindung zwischen den Schirmen BLS, BLS' der koaxialen Busleitung.

Der Abstand der Abschirmplatten SCH1, SCH2 von den Leiterbahnen LB1, LB2 ist durch die Dicke der Isolierstoffträger IT1, IT2 gegeben und ist so gewählt, daß der Wellenwiderstand der Leiterbahnen LB1, LB2 gleich dem der koaxialen Busleitung BLA, BLS ; BLA', BLS' ist. In jede Abschirmplatte sind vier Löcher gebohrt, durch welche die Schenkel der Magnetkerne KS, KE durchgreifen. Zur Vermeidung von Kurzschlußströmen sind die Abschirmplatten zwischen den Löchern, in denen sich die Schenkel eines Magnetkernes befinden, geschlitzt. Ferner sind die Durchmesser der Löcher in der Metallschicht größer als die im Isolierstoffträger, damit ein elektrischer Kontakt zwischen Metallschicht und Magnetkern vermieden ist.

Über der Abschirmplatte SCH2 befindet sich eine dritte Abschirmplatte SCH3, die ebenfalls auf einem Isolierstoffträger IT3 aufgebracht ist. Da der Abstand zwischen den beiden Abschirmplatten SCH2, SCH3 möglichst groß sein soll, wird die Dicke des Isolierstoffträgers IT3 im allgemeinen so groß gewählt, wie es die Magnetkerne KE, KS zulassen. Der Isolierstoffträger IT3 wird daher dicker sein als die Träger IT1, IT2. Die Abschirmplatte SCH3 und die Abschirmung SCH4 der Sekundärwicklung WE2 des Empfänger-Übertragers sind mit dem Schirm SCH5 der symmetrischen Koaxialleitung verbunden, der auf dem Nullpotential des Empfängers liegt.

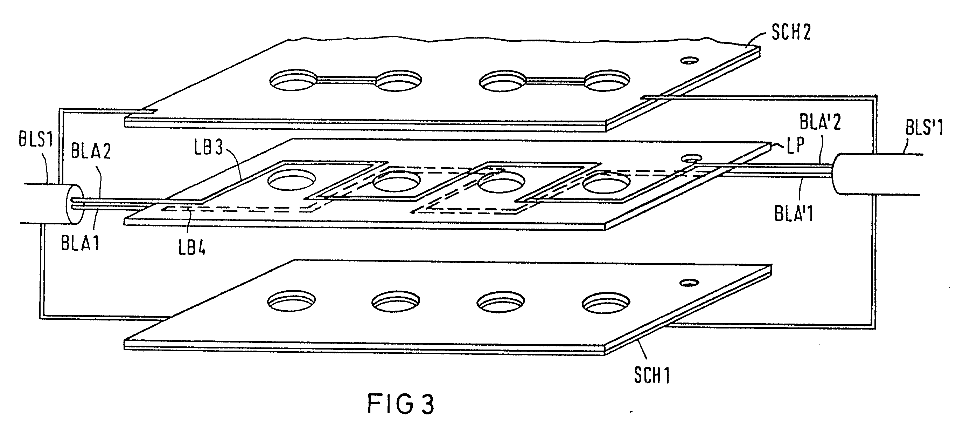

In Figur 3 ist eine Ausgestaltung der Erfindung für symmetrische Busleitungen dargestellt. Der Schirm der Busleitung ist mit BLS1, BLS'1 bezeichnet, die beiden Adern mit BLA1, BLA2 bzw. BLA'1, BLA'2. Die beiden Adern BLA1, BLA2 sind mit den einen Enden von mäanderförmigen Leiterbahnen LB3, LB4 verbunden, die in gleicher Weise wie die in der Anordnung nach Figur 2 ausgebildet sind. Im Gegensatz zur Anordnung nach Figur 2 besteht jedoch an ihrem anderen Ende keine elektrische Verbindung zwischen ihnen, sondern sie sind an die Fortführung BLA'1, BLA'2 der beiden Adern der symmetrischen Busleitung angeschlossen. Die Abschirmung BLS1, BLS'1 der Busleitung ist mit den Schirmen SCH1, SCH2 der mäanderförmigen Leiterbahnen LB3, LB4 verbunden. Die übrigen in Figur 2 dargestellten Bauelemente können auch in der Anordnung nach Figur 3 verwendet werden, so daß auf ihre Darstellung und Beschreibung verzichtet werden kann. Auch hinsichtlich Funktion und Wirkung stimmen die beiden Anordnungen überein.

**Ansprüche**

1. In eine geschirmte Busleitung (BLA, BLS ; BLA', BLS') einschaltbarer induktiver Signalkoppel mit mindestens einem Übertrager, dessen Primärwicklung (WE1) als zumindest einen Schenkel des Magnetkernes (KE) des Übertragers umschlingende Leiterbahn (LB1, LB2) einer Leiterplatte (LP) ausgebildet ist, wobei parallel zur Leiterplatte (LP) zwei mit dem Schirm (BLS, BLS') der Busleitung elektrisch verbundene Abschirmplatten in solchem Abstand angeordnet sind, daß die Leiterbahn (LB1, LB2) den Wellenwiderstand der Busleitung besitzt, dadurch gekennzeichnet, daß zwischen der einen Abschirmplatte (SCH2) und der Sekundärwicklung (WE2) des Übertragers eine parallel zur Leiterplatte (LP) und den beiden Abschirmplatten (SCH1, SCH2) verlaufende dritte Abschirmplatte (SCH3) angeordnet ist, die mit dem Massepotential eines Empfängers (EM) verbunden ist.

2. Signalkoppler nach Anspruch 1, dadurch gekennzeichnet, daß die Sekundärwicklung (WE2) des Übertragers mit einer mit dem Nullpotential des Empfängers (EM) verbundenen Abschirmung (SCH4) versehen ist.

3. Signalkoppler nach Anspruch 1 oder 2, dadurch gekennzeichnet, daß der Kern (KS) des Übertragers zwei Schenkel hat, die durch je zwei Löcher in den Abschirmplatten (SCH1, SCH2, SCH3) und der Leiterplatte (LP) hindurchgreifen.

4. Signalkoppler nach Anspruch 3, dadurch gekennzeichnet, daß die Leiterplatte (LP) doppelt kaschiert ist, daß auf jeder Seite der doppelt kaschierten Leiterplatte (Lp) ein mäanderförmiger, die Magnetkernschenkel in entgegengesetztem Sinn umlaufende Leiterbahn (LB1 bzw. LB2) vorhanden ist und daß sie sich zu die Schenkel des Übertragerkerns (KE) umgebenden Stromkreisen ergänzen, indem sie bezüglich der in den Magnetkernschenkeln liegenden Ebene symmetrisch verlaufen.

5. Signalkoppler nach Anspruch 4, dadurch gekennzeichnet, daß die auf jeder Seite der doppelt kaschierten Leiterplatte (LP) angebrachten Leiterbahnen (LB1 bzw. LB2 ; LB3 bzw. LB4) so gestaltet und angeordnet sind, daß sie sich zu vier Stromkreisen ergänzen, die Wicklungen für zwei zweischenklige Magnetkerne (KS, KE) bilden, die durch vier Löcher in der Leiterplatte gesteckt sind und von denen der eine (KS) eine mit einem Sender (SE) verbundene Primärwicklung (WS1) und der andere die mit dem Empfänger (EM) verbundene Sekundärwicklung (WE2) trägt.

6. Signalkoppler nach Anspruch 1 bis 5, dadurch gekennzeichnet, daß die Abschirmplatten (SCH1, SCH2) jeweils zwischen den Löchern, in denen sich die Schenkel der Magnetkerne (KE, KS) befinden, geschlitzt sind.

7. Signalkoppler nach Anspruch 1 bis 6, dadurch gekennzeichnet, daß die Leiterbahnen (LB1, LB2) an ihren einen Enden an die asymmetrische Busleitung (BLA, BLA') angeschlossen sind und an ihren anderen Enden miteinander elektrisch verbunden sind.

8. Signalkoppler nach Anspruch 1 bis 6, dadurch gekennzeichnet, daß die Leiterbahnen (LB3, LB4) an ihren Enden mit den beiden Adern (BLA1, BLA2 ; BLA'1, BLA'2) einer symmetrischen Busleitung verbunden sind.

9. Signalkoppler nach einem der Ansprüche 1 bis 8, dadurch gekennzeichnet, daß die dritte Abschirmplatte (SCH3) größer als die beiden Abschirmplatten (SCH1, SCH2) ist.

**Claims**

1. An inductive signal coupler which can be connected into a screened busline (BLA, BLS ; BLA', BLS') with at least one transformer whose primary winding (WE1) is designed as a conductor path (LB1), LB2, encircling at least one flank of the magnetic core (KE) of the transformer, of a circuit board (LP), where two screening plates which are electrically connected to the screen (BLS, BLS') of the busline are arranged parallel to the circuit board (LP) at a distance which is such that the conductor path (LB1, LB2) has the surge impedance of the busline, characterised in that between the one screening plate (SCHE) and the secondary winding (WE2) of the transformer there is arranged a thir screening plate (SCH3) extending parallel to the circuit board (LP) and the two screening plates (SCH1, SCH2) and which is connected to the earth potential of a receiver (EM).

2. A signal coupler as claimed in claim 1, characterised in that the secondary winding (WE2) of the transformer is provided with a screen (SCH4) which is connected to the zero potential of the receiver (EM).

3. A signal coupler as claimed in claim 1 or 2, characterised in that the core (KS) of the transformer has two flanks which each pass through two apertures in the screening plates (SCH1, SCH2, SCH3) and the circuit board (LP).

4. A signal coupler as claimed in claim 3, characterised in that the circuit board (LP) is double-sided, that a serpentine conductor path (LB1 and LB2) which encircles the flanks of the magnetic core in an opposing direction is arranged on each side of the double-sided circuit board (LP), and that these supplement one another to form circuits which surround the transformer core (KE) in that they are symmetrical relative to the plane which lies in the magnetic core flanks.

5. A signal coupler as claimed in claim 4, characterised in that the conductor paths (LB1, LB2 ; LB3, LB4) which are arranged on each side of the double-sided circuit board (LP) are designed and arranged in such manner that they supplement one another to form four circuits which form windings for two two-flanked magnetic cores (KS, KE) which are passed through four apertures in the circuit board and of which one (KS) bears a primary winding (WS1) which is connected to a transmitter (SE) and the other bears the secondary winding (WE2) which is connected to the receiver (EM).

6. A signal coupler as claimed in claims 1 to 5, characterised in that the screening plates (SCH1, SCH2) are each slotted between the apertures in which the flanks of the magnetic cores (KE, KS) are located.

7. A signal coupler as claimed in claims 1 to 6, characterised in that at their one ends the conductor paths (LB1, LB2) are connected to the asymmetrical busline (BLA, BLA') and at their other ends they are electrically connected to one another.

8. A signal coupler as claimed in claims 1 to 6, characterised in that at their ends the conductor paths (LB3, LB4) are connected to the two wires (BLA1, BLA2 ; BLA'1, BLA'2) of a symmetrical busline.

9. A signal coupler as claimed in one of the claims 1 to 8, characterised in that the third screening plate (SCH3) is larger than the two screening plates (SCH1, SCH2).

**Revendications**

1. Coupleur inductif de signaux, pouvant être branché dans une ligne de transmission bus blindée (BLA, BLS ; BLA' BLS') et comportant au moins un transformateur dont l'enroulement primaire (WE1) est réalisé sous la forme d'une voie conductrice (LB1, LB2) d'une plaquette à circuits imprimés (LP), entourant au moins une branche du noyau magnétique (KE) du transformateur, et dans lequel deux plaques de blindage reliées électriquement au blindage (BLS, BLS') de la ligne de transmission bus sont disposées parallèlement à la plaque à circuits imprimés (LP) et à une distance telle de cette plaque que la voie conductrice (LB1, LB2) possède l'impédance caractéristique de la ligne de transmission bus, caractérisé par le fait qu'entre l'une des plaques de blindage (CH2) et l'enroulement secondaire (WE2) du transformateur se trouve disposée une troisième plaque de blindage (SCH3) s'étendant parallèlement à la plaquette à circuits imprimés (LP) et aux deux plaques de blindage (SCH1, SCH2) et qui est reliée au potentiel de masse d'un récepteur (EM).

2. Coupleur de signaux suivant la revendication 1, caractérisé par le fait que l'enroulement secondaire (WE2) du transformateur est muni d'un blindage (SCH4) relié au potentiel nul du récepteur (EM).

3. Coupleur de signaux suivant la revendication 1 ou 2, caractérisé par le fait que le noyau (KS) du transformateur comporte deux branches qui traversent deux trous respectifs ménagés dans les plaques de blindage (SCH1, SCH2, SCH3) et dans la plaquette à circuits imprimés (LP).

4. Coupleur de signaux suivant la revendication 3, caractérisé par le fait que la plaquette à circuits imprimés (LP) comporte un placage double de telle sorte qu'il existe sur chaque face de la plaquette à circuits imprimés (LP) munie d'un placage double, une voie conductrice de forme sinueuse (LB1 ou LB2) circulant en sens opposé autour des branches du noyau magnétique et que ces voies conductrices se complètent pour former des circuits entourant les branches du noyau (KE) du transformateur, par le fait qu'elles s'étendent symétriquement par rapport au plan contenant les branches du noyau magnétique.

5. Coupleur de signaux suivant la revendication 4, caractérisé par le fait que les voies conductrices (LB1 ou LB3 ; LB3 ou LB4) disposées sur les deux faces de la plaquette à circuits imprimés (LP) munie d'un placage double, sont agencées et disposées de telle sorte qu'elles se complètent pour former quatre circuits qui forment des enroulements pour deux noyaux magnétiques (KS, KE) à deux branches, qui s'étendent à travers quatre trous de la plaquette à circuits imprimés et dont l'un (KS) porte un enroulement primaire (WS1) relié à un émetteur (SE) et dont l'autre porte l'enroulement secondaire (WE2) relié au récepteur (EM).

6. Coupleur de signaux suivant la revendication 1 à 5, caractérisé par le fait que les plaques de blindage (SCH1, SCH2) sont fendues respectivement entre les trous, dans lesquels les branches du noyau magnétique (KE, KS) sont situées.

7. Coupleur de signaux suivant les revendications 1 à 6, caractérisé par le fait que les voies conductrices (LB1, LB2) sont raccordées, à l'une de leurs extrémités, à la ligne de transmission bus dissymétrique (BLA, BLA') et sont reliées électriquement entre elles par leurs autres extrémités.

8. Coupleur de signaux suivant les revendications 1 à 6, caractérisé par le fait que les voies conductrices (LB3, LB4), sont reliées à leurs extrémités aux deux conducteurs (BLA1, BLA2 ; BLA'1, BLA'2) d'une ligne de transmission bus symétrique.

9. Coupleur de signaux suivant l'une des revendications 1 à 8, caractérisé par le fait que la troisième plaque de blindage (SCH3) possède une taille plus importante que les deux autres plaques de blindage (SCH1, SCH2).

FIG 1

FIG 2

FIG 3